(19) Europäisches Patentamt / European Patent Office / Office européen des brevets

(11) **EP 3 259 617 B1**

(12) **FASCICULE DE BREVET EUROPEEN**

(45) Date de publication et mention de la délivrance du brevet:
**05.12.2018 Bulletin 2018/49**

(21) Numéro de dépôt: **16705135.8**

(22) Date de dépôt: **17.02.2016**

(51) Int Cl.:
*G01T 1/167* (2006.01)    *G01T 7/00* (2006.01)

(86) Numéro de dépôt international:
**PCT/EP2016/053319**

(87) Numéro de publication internationale:
**WO 2016/131852 (25.08.2016 Gazette 2016/34)**

(54) **PROCEDE DE QUANTIFICATION DES DIMENSIONS INTRINSEQUES DES CAPTEURS DE RAYONNEMENTS, NOTAMMENT DES CAPTEURS DE RAYONNEMENTS IONISANTS, ET DISPOSITIF POUR LA MISE EN OEUVRE DU PROCEDE**

VERFAHREN ZUR QUANTIFIZIERUNG DER INTRINSISCHEN ABMESSUNGEN VON STRAHLUNGSSENSOREN, INSBESONDERE IONISIERENDER STRAHLUNGSSENSOREN, UND VORRICHTUNG ZUR DURCHFÜHRUNG DES VERFAHRENS

METHOD FOR QUANTIFYING THE INTRINSIC DIMENSIONS OF RADIATION SENSORS, PARTICULARLY IONIZING RADIATION SENSORS, AND DEVICE FOR IMPLEMENTING SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.02.2015 FR 1551427**

(43) Date de publication de la demande:
**27.12.2017 Bulletin 2017/52**

(73) Titulaire: **Commissariat à l'Énergie Atomique et aux Énergies Alternatives 75015 Paris (FR)**

(72) Inventeurs:
  • **SAUREL, Nicolas 21490 Varois-et-Chaignot (FR)**
  • **GUILLOT, Nicolas 03240 Cressanges (FR)**

(74) Mandataire: **Brevalex 95, rue d'Amsterdam 75378 Paris Cedex 8 (FR)**

(56) Documents cités:
**WO-A1-2014/085081**

• **VENKATARAMAN R ET AL: "Improved detector response characterization method in ISOCS and LabSOCS", JOURNAL OF RADIOANALYTICAL AND NUCLEAR CHEMISTRY, KLUWER ACADEMIC PUBLISHERS, DO, vol. 264, no. 1, 1 mars 2005 (2005-03-01), pages 213-219, XP019251919, ISSN: 1588-2780 cité dans la demande**
• **VENKATARAMAN R ET AL: "Validation of in situ object counting system (ISOCS) mathematical efficiency calibration software", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, vol. 422, no. 1-3, 11 février 1999 (1999-02-11), pages 450-454, XP004161875, ISSN: 0168-9002, DOI: 10.1016/S0168-9002(98)01115-2**

**Description**

**DOMAINE TECHNIQUE**

La présente invention concerne un procédé de quantification des dimensions intrinsèques des capteurs de rayonnements, ainsi qu'un dispositif pour la mise en oeuvre de ce procédé.

Indiquons dès à présent que le dispositif permet de dimensionner les éléments du capteur, afin de pouvoir définir le modèle numérique équivalent à la réponse expérimentale de ce capteur, et que l'invention permet (a) de réaliser ce type de dimensionnement de façon simple, sans hypothèse forte sur les caractéristiques intrinsèques du capteur et uniquement à partir des plans de principe de celui-ci, (b) de fournir la justesse associée à ce dimensionnement par rapport à la réponse réelle du capteur et (c) d'automatiser ces opérations. Indiquons aussi que ce dispositif utilise un dispositif de mesure de la réponse du capteur, portant une source d'émission de rayonnements ayant diverses fréquences et donc diverses énergies, et permettant d'ajuster les dimensions inconnues recherchées du capteur par l'intermédiaire d'un procédé spécifique.

L'invention s'applique notamment à la métrologie des spectromètres de rayonnements. De par ses caractéristiques, le domaine d'application du dispositif s'étend à tous les capteurs spectrométriques qui sont destinés au contrôle non destructif et dont la réponse ainsi que le transport des rayonnements associés peuvent être numérisés ou calculés. Cela concerne donc les spectromètres de mesure des rayonnements ionisants tels que, par exemple, les spectromètres gamma, alpha, ultraviolets, infrarouges, visibles, et donc tous les systèmes photographiques. On se concentrera par la suite sur les capteurs de rayonnements ionisants, plus particulièrement sur les capteurs en germanium hyper-pur, mais le principe de l'invention est facilement extensible à tout autre capteur de rayonnement dont il est possible de numériser la réponse.

**ÉTAT DE LA TECHNIQUE ANTÉRIEURE**

La connaissance des dimensions intrinsèques d'un capteur de rayonnements, permettant de restituer sa réponse, est primordiale lorsqu'on veut numériser la réponse de ce capteur.

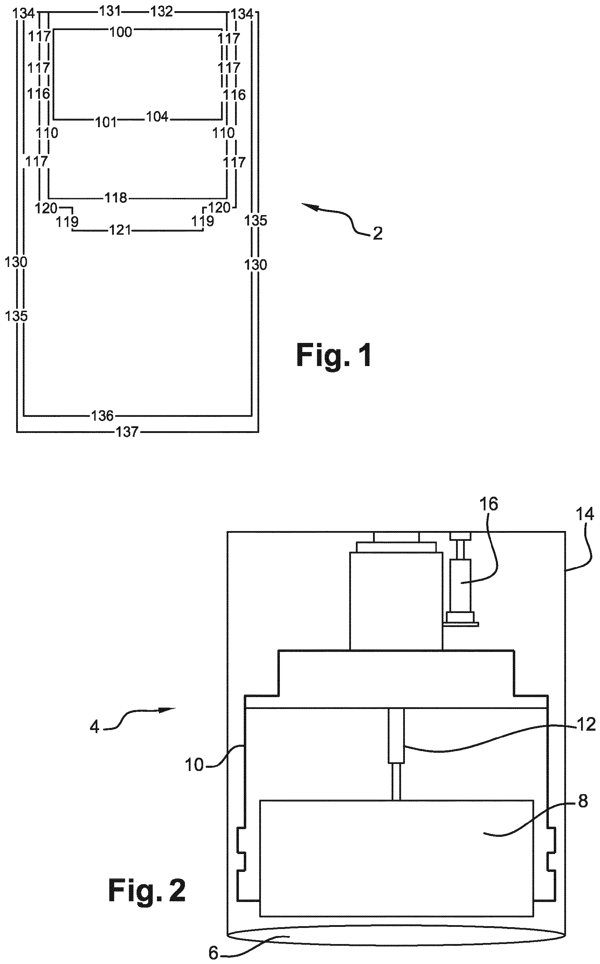

La modélisation du capteur permet de calculer, pour chaque configuration de mesure, le ou les coefficients d'étalonnage utiles à la quantification de la grandeur recherchée, par exemple l'activité radiologique, pour toute fréquence, et donc toute énergie, du spectre du domaine de validité d'un capteur de rayonnements ionisants. Cette modélisation consiste à établir une représentation géométrique du capteur dans un code de calcul. Un exemple d'une telle représentation est donné, à titre purement indicatif et nullement limitatif, sur la figure 1 des dessins annexés, où le capteur a la référence 2. Les divers nombres que l'on voit sur cette figure représentent les numéros des surfaces servant à délimiter les différents volumes numérisés, constitutifs du capteur.

Ce procédé est bien connu. A son sujet, on se reportera notamment aux documents suivants :

**[1]** WO 98/39628, F. Bronson et al.**, Calibration method for radiation spectroscopy**

**[2]** F. Bronson et al., Validation of the MCNP Monte Carlo Code for germanium detector gamma efficiency calibrations, Canberra Industries, U.S.A., 1996

**[3]** R. Venkataraman et al., Improved detector response characterization method in ISOCS and LabSOCS, Journal of Rad. Nucl. Chem., vol. 264, pp. 213-219, 2005**.**

Ce procédé connu est toutefois lourd à mettre en oeuvre et nécessite un savoir faire particulier.

La quantification des dimensions intrinsèques qui influent sur la réponse du capteur est actuellement fondée sur la connaissance exacte des dimensions des différents éléments constituant ce capteur. Toutefois, cette quantification est délicate du fait que le capteur possède un nombre élevé d'éléments constitutifs et que certaines dimensions ne sont pas directement mesurables ou ne peuvent être mesurées avec une précision suffisante pour restituer correctement l'effet produit sur la réponse du capteur. Ainsi, la numérisation du capteur demeure délicate, nécessite un fort retour d'expérience et n'est pas exempte d'erreurs d'étalonnage.

Indiquons dès maintenant que la présente invention vise à résoudre ces problèmes en simplifiant la technique d'obtention du modèle numérique équivalent du capteur, en renforçant la robustesse de cette technique et en l'automatisant.

L'invention est notamment applicable à tout type de spectromètre de mesure de rayonnement ionisant.

Le domaine d'application du type de dimensionnement considéré dans l'invention concerne le contrôle non destructif par émission de rayonnement et, plus particulièrement, la modélisation numérique des capteurs de rayonnements ionisants. Cette modélisation permet ensuite d'établir, à l'aide d'un code de calcul approprié, le coefficient d'étalonnage à appliquer pour la quantification de la grandeur recherchée, par exemple l'activité radiologique.

Remarquons aussi que l'obtention de dimensions, conformément à l'invention, va permettre d'utiliser tout code de calcul souhaité, et même de confronter les réponses de plusieurs codes de calcul.

La mesure d'intensité d'une source de rayonnements est fondée sur l'établissement de la correspondance entre le nombre de rayonnements émis par unité de temps et le nombre de ces mêmes rayonnements, enregistrés et réellement déclarés par le spectromètre utilisé pour mesurer ces rayonnements. Cette correspondance est appelée « rendement de détection ». Elle sera ainsi dénommée dans toute la suite de la description. Le fait de disposer d'un capteur spectral permet de séparer plusieurs fréquences, et donc plusieurs énergies, et de réaliser une mesure d'intensité sur chacune d'entre elles. Cette technique est utilisée dans le domaine du contrôle non destructif depuis plusieurs décennies et elle est largement normalisée. A ce sujet, on se reportera par exemple au document suivant :

**[4] Standard test methods for detector calibration and analysis of radionuclides, ASTM international, E181-10.**

L'intégration judicieuse de la géométrie du capteur dans un code de calcul de transport de rayonnements ou de particules, que l'on a validé, permet de quantifier les coefficients d'étalonnage de façon numérique, sans aucun recours à des étalons expérimentaux. La figure 2 des dessins annexés montre les éléments constitutifs d'un exemple de capteur au germanium hyper-pur 4.

Sur cette figure, les références 6, 8, 10, 12, 14 et 16 représentent respectivement une fenêtre d'entrée en carbone époxy, un cristal de germanium hyper-pur, un support, un contact central, un capot et un préamplificateur maintenu à basse température.

Dans l'art antérieur, la géométrie du capteur est intégrée dans le code de calcul, en reconstituant le plus précisément possible les éléments du capteur à partir de toutes les données disponibles. Les premières données utilisées sont les dimensions qui sont directement relevées sur les différents éléments avant assemblage (capot, fenêtre d'entrée, support, etc.) qui sont fournis par le constructeur (voir le document [1]). Toutes ces dimensions permettent de modéliser le capteur. Toutefois, surtout lorsque le constructeur n'est pas le fournisseur de la géométrie du capteur, des différences notables peuvent apparaître entre les données fournies et la réalité (voir le document [2]).

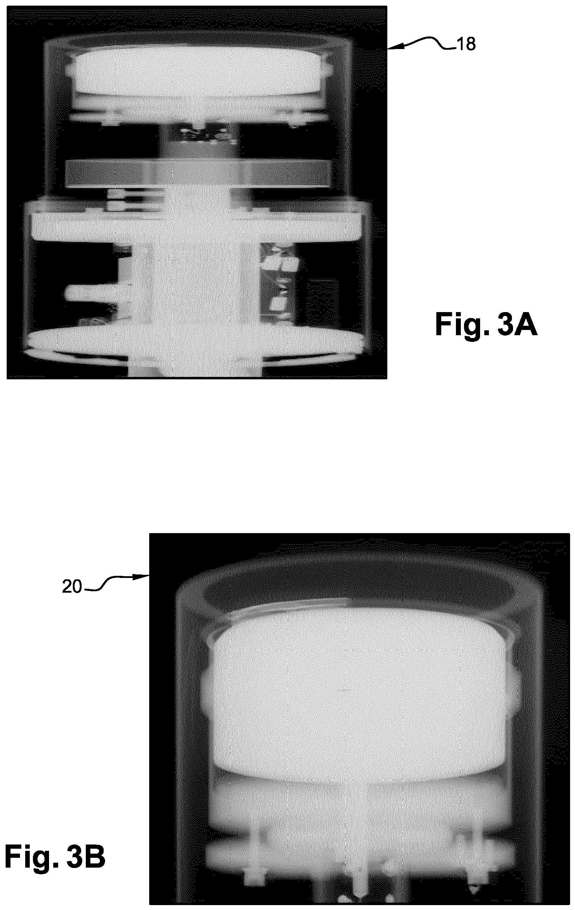

En effet, le retour d'expérience montre que des différences géométriques peuvent apparaître, tel qu'un léger déplacement du cristal dans son support, dû au tirage sous vide lors du montage du capteur. L'adéquation de la géométrie réelle du capteur avec les données fournies par le constructeur, notamment les plans du capteur, est alors contrôlée par une radiographie X. Pour un spectromètre gamma au germanium, la densité du germanium, qui est le constituant majeur de la partie active du capteur, fait qu'il est nécessaire de recourir à des radiographies spécifiques à haute énergie afin d'obtenir une image suffisamment résolue. Si tel n'est pas le cas, il sera très difficile, voire impossible, d'exploiter les données fournies par la radiographie, à savoir le relevé des positions exactes des éléments constitutifs du capteur et le contrôle des cotes géométriques. Même avec une image bien résolue, les effets de parallaxe rendent complexe un relevé de cotes précis. Cette difficulté est illustrée par les figures 3A et 3B qui représentent des radiographies, plus ou moins bien définies, de deux exemples de capteurs en germanium hyper-pur, ayant respectivement les références 18 et 20 sur les figures 3A et 3B. Il est à noter qu'une variation de 2 mm sur la longueur ou sur le diamètre du cristal de germanium, par rapport à une valeur de référence, peut modifier le rendement de détection de 11% pour un point de mesure situé à 10 cm en face du capteur. Et le rendement de détection vaut 0,0222 pour un point de mesure situé à 67 mm, et 0,0247 pour un point de mesure situé à 71 mm. On évalue à 2 mm l'erreur faite sur un relevé de dimensions, réalisé à partir d'une radiographie telle que celles qui sont présentées sur les figures 3A et 3B (voir le document [3]).

A ces dimensions directement mesurables viennent s'ajouter des données difficilement accessibles par mesure directe. Il s'agit de la répartition du dopant dans le cristal : du fait de son accumulation, ce dopant peut générer des pertes de rendement de détection. Il s'agit aussi de la répartition des lignes de champ dans le cristal : du fait qu'elles ne peuvent couvrir de façon homogène l'ensemble du cristal, ces lignes de champ créent aussi une perte de rendement de détection. Il s'agit enfin de l'électronique de collecte des charges qui, elle aussi, « perd » des charges, ce qui conduit à une perte globale de rendement de détection.

L'influence de l'ensemble de ces données varie en fonction de la position dans l'espace de la source de rayonnements par rapport au capteur. Cette position est définie par la distance de la source au capteur et par l'angle formé par la droite les joignant l'un à l'autre avec une droite de référence.

Il devient ainsi compliqué de définir une géométrie possédant une réponse identique à celle du capteur réel, pour toutes les positions dans l'espace d'émission de rayonnement. A ce sujet, on se reportera au document suivant :

**[5] Model S573/S574 ISOCS/LabSOCS, Validation** & **vérification manual, V4.0, 9231205E.**

Pour palier ces effets, un raccordement métrologique est réalisé à partir d'une ou plusieurs positions dans l'espace, et les écarts constatés sont compensés par l'intégration, à la géométrie du cristal, d'une couche dénommée « zone morte ». Cette couche sert ainsi à compenser tous les effets des pertes de charges et des pertes qui sont dues aux lignes de champs et à la concentration de dopant en certains endroits du cristal. Il subsiste néanmoins un postulat de base selon lequel (a) soit les dimensions relevées sur la radiographie X, soit celles qui sont fournies par le constructeur, sont justes, et (b) l'erreur faite lors du relevé de dimensions est suffisamment faible pour qu'elle n'ait pas d'impact sur le rendement de détection. Toutefois, cette dernière condition n'est pas toujours réalisée. On a vu en effet qu'une erreur de l'ordre de 2 millimètres sur une dimension entraînait une erreur de 11% sur le rendement de détection.

Les documents suivants divulguent également la modélisation d'un détecteur:

-    WO 2014/085081 A1;
-    VENKATARAMAN R ET AL: "Validation of in situ object counting system (ISOCS) mathematical efficiency calibration software",NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, vol. 422, no. 1-3, 11 février 1999 (1999-02-11), pages 450-454, XP004161875,ISSN: 0168-9002, DOI: 10.1016/ S0168-9002(98)01115-2.

## EXPOSÉ DE L'INVENTION

La présente invention a pour but de remédier aux inconvénients précédents.

Elle a pour objet un procédé de quantification des dimensions intrinsèques d'un capteur de rayonnements, le procédé comprenant les étapes suivantes :

-    définition et réalisation d'une modélisation du capteur, à partir d'un schéma de principe du capteur,
-    identification, par un calcul numérique, des éléments influents du capteur, par l'intermédiaire de la théorie des plans d'expérience,
-    réalisation de mesures, pour différentes positions particulières de l'espace autour du capteur, au moyen d'une source étalon multifréquences (ou multiénergies) desdits rayonnements, et
-    dimensionnement des éléments qui influent sur la réponse du capteur, par l'intermédiaire de la théorie des plans d'expérience.

Selon un mode de réalisation préféré du procédé, objet de l'invention, l'étape de détermination des éléments influents du capteur est suivie d'une étape de vérification, par une méthode d'analyse des résidus, qu'aucun élément influent n'a été omis.

De préférence, on fait tourner la source de rayonnements autour du capteur pour réaliser les mesures sous plusieurs angles et à au moins une distance donnée du capteur.

Selon un mode de réalisation préféré de l'invention, on recherche le niveau optimal de chaque élément influent du capteur.

De préférence, on recherche le niveau optimal par la méthode du gradient réduit généralisé.

Selon un mode de réalisation particulier de l'invention, la source est une source étalon multifréquences (ou multiénergies) de rayonnements ionisants, d'activité connue, en vue de quantifier les dimensions intrinsèques d'un capteur desdits rayonnements ionisants.

La présente invention concerne aussi un dispositif pour la mise en oeuvre du procédé, objet de l'invention, comprenant :

-    un ordinateur configuré pour exécuter un logiciel pour la réalisation des étapes de modélisation, de détermination et de dimensionnement du procédé,
-    un dispositif de fixation du capteur, comprenant deux équerres, adapté pour maintenir fermement le capteur et permettre un centrage par rapport à celui-ci,
-    un dispositif de référence, adapté pour fournir un point de référence pour les mesures,
-    un dispositif de support de la source, et
-    un dispositif pivotant, solidaire du dispositif de support de la source.

Selon un mode de réalisation préféré du dispositif, objet de l'invention, ce dispositif comprend en outre un dispositif amovible et réglable en hauteur pour maintenir au sol le dispositif de fixation du capteur.

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

-    la figure 1 illustre schématiquement un exemple de modélisation numérique d'un capteur de rayonnements ionisants, et a déjà été décrite,
- la figure 2 illustre schématiquement les éléments constitutifs d'un exemple de capteur en germanium hyper-pur, et a déjà été décrite,
- les figure 3A et 3B représentent respectivement des radiographies de deux exemples de capteurs en germanium hyper-pur, et ont déjà été décrites,
- la figure 4 illustre schématiquement un exemple d'un schéma coté d'un capteur de rayonnements ionisants,
- la figure 5 est une vue en perspective schématique d'un mode de réalisation particulier du dispositif, objet de l'invention,
- la figure 6 est une vue en perspective schématique d'une variante de réalisation du dispositif représenté sur la figure 5, et
- les figures 7A, 7B et 7C illustrent schématiquement différentes géométries connues pour des capteurs de rayonnements ionisants.

## EXPOSÉ DÉTAILLÉ DE MODES DE RÉALISATION PARTICULIERS

On donne dans ce qui suit des exemples du procédé de dimensionnement, objet de l'invention, et du dispositif mécanique pour la mise en oeuvre de ce procédé, permettant la quantification des dimensions des éléments qui influent sur le rendement de détection d'un capteur de rayonnements ionisants.

Notons que tous les éléments nécessaires à l'obtention du dispositif de mesure sont simples à fabriquer, du point de vue mécanique. Et tous les outils nécessaires au procédé de dimensionnement sont commercialement disponibles ou connus dans l'état de la technique.

L'invention concerne leur association et leur mise en oeuvre.

Les dimensions des éléments, que l'on recherche, sont obtenues de la façon suivante :

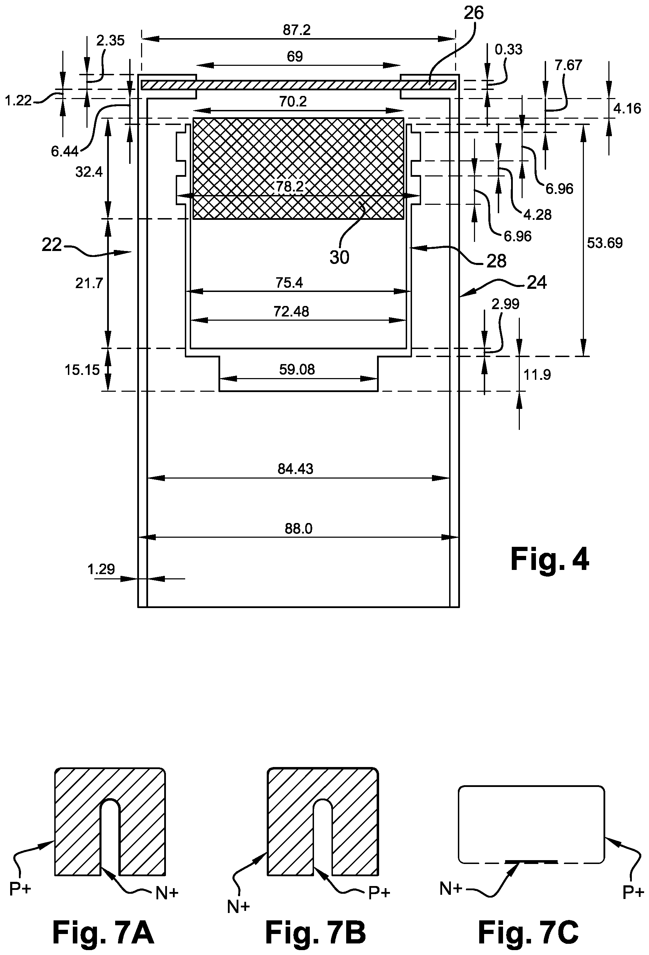

• On définit et l'on réalise un modèle géométrique dans un code de calcul, à partir du schéma de principe coté du capteur de rayonnements ionisants. Un tel schéma est représenté sur la figure 4 où les cotes sont exprimées en millimètres, avec une incertitude de +/- 0,2 mm. Cette incertitude correspond aux tolérances de réalisation mécanique mais pas à l'incertitude de positionnement des éléments après montage et assemblage. Ce schéma permet de se faire une idée du degré de précision et de détails qui sont requis pour cette première étape.

• On détermine les éléments influents par l'intermédiaire de la théorie des plans d'expérience qui permet de faire une analyse de sensibilité. Cette analyse fournit ces éléments influents parmi tous les éléments de structure qui constituent le capteur. Cette étape est réalisée uniquement par calcul numérique : aucune expérience n'est requise.

• On effectue des mesures pour différentes positions particulières de l'espace autour du capteur. Un relevé précis des coordonnées de mesure est effectué. Ces mesures sont effectuées avec une source d'émission des rayonnements ionisants considérés. Cette source est une source étalon multifréquences (ou multiénergies) ayant une activité connue, exprimée en unités SI.

• On dimensionne les éléments qui influent sur la réponse du capteur, par l'intermédiaire de la théorie des plans d'expérience.

Tout type de capteur de rayonnements peut être ainsi étalonné du moment qu'il existe un code de calcul permettant la reproduction suffisamment précise du capteur en trois dimensions ainsi que le transport des rayonnements caractéristiques, objets de l'étalonnage.

On indique dans ce qui suit les définitions et terminologies utilisées par la suite dans la description du procédé permettant de déterminer les éléments influant sur la réponse du capteur.

Facteurs

Les facteurs sont les paramètres du système étudié. Dans le cas présent, ils correspondent aux éléments caractéristiques du capteur, qui influent directement sur la réponse de celui-ci. Les facteurs prennent diverses valeurs au cours de la réalisation d'un plan d'expérience.

Niveaux

Les facteurs déterminés pour le plan d'expérience varient sur un domaine d'étude. Ils peuvent varier de façon continue, en prenant une infinité de valeurs possibles, ou de façon discrète, en prenant un nombre fini de valeurs choisies. Ce sont les différents niveaux d'un facteur. Les facteurs utilisés dans le cadre de la présente invention se limitent à trois niveaux possibles : les bornes supérieure et inférieure du domaine et la valeur médiane entre ces bornes.

Réponse(s)

Une réponse est une grandeur de sortie, ou une fonction d'une grandeur de sortie, qui est fournie par un essai.

Modèle de comportement

Il s'agit d'une relation mathématique qui donne la réponse en fonction des facteurs. Le traitement des données issues d'un plan d'expérience consiste à étudier l'écart entre les résultats annoncés par le modèle (résultats prévisionnels) et les résultats expérimentaux obtenus après une série d'essais.

On considère à présent la détermination des facteurs qui influent sur la réponse du capteur.

Cette détermination est établie en utilisant la théorie des plans d'expérience. Toutefois, contrairement à l'utilisation « classique » des plans d'expérience, on ne cherche pas ici à définir un modèle de comportement mais à optimiser des paramètres, à savoir les dimensions des éléments constitutifs du capteur.

Établir un plan d'expériences revient à définir l'ensemble des essais, à savoir l'ensemble des combinaisons des facteurs et des niveaux de ceux-ci, que l'on doit réaliser pour étudier l'influence de chaque facteur sur la réponse du capteur. Un plan de screening est un plan dit "réduit", parce qu'il ne nécessite pas de réaliser toutes les combinaisons possibles de facteurs et de niveaux pour l'étude considérée. En fait, un plan de screening consiste à sélectionner certaines combinaisons représentatives d'une étude globale des facteurs. Il permet naturellement de réduire le temps d'exécution d'un plan, mais diminue en contrepartie les informations disponibles sur le comportement du système.

L'utilisation de ce type de plan permet d'identifier les éléments les plus influents sur la réponse du capteur et d'évaluer les bornes de variation potentielle de chaque facteur. Il n'est pas nécessaire de quantifier précisément ces influences avec ce premier plan. Il s'agit finalement d'un «balayage» de la globalité des facteurs. Ce plan permet aussi de déterminer quels sont les facteurs qui influent les uns sur les autres. Et il est important de bien dissocier l'influence des facteurs sur les réponses et la corrélation de facteurs, c'est-à-dire l'influence des facteurs les uns sur les autres.

Concrètement, il faut commencer par lister les facteurs à introduire dans le plan d'expérience puis spécifier les valeurs des niveaux de ces facteurs. La suite du procédé dépend des réponses qu'apporte le plan de screening.

Pour un capteur au germanium, la liste des facteurs est donnée par le schéma de principe coté, fourni par le fabricant du capteur. A titre d'exemple, en faisant référence à la figure 4, sur laquelle les cotes du capteur 22 sont exprimées en millimètres, ces facteurs peuvent être :

- la longueur et le diamètre du capot 24 ;
- le diamètre et l'épaisseur de la fenêtre d'entrée 26 ;
- l'épaisseur et le diamètre du support 28 du cristal de germanium ;
- la longueur et le diamètre du cristal 30, et la longueur et le diamètre du « doigt de contact », si le cristal en possède un ;
- les épaisseurs de « zones mortes équivalentes » qui sont situées à l'avant, sur les côtés et à l'arrière du cristal de germanium.

Les bornes de variation associées à ces facteurs seront, par exemple, les erreurs de mesure que l'on estime lors de leur quantification.

Cette étape est réalisée de façon entièrement numérique. En effet, une fois que sont établis les facteurs à étudier ainsi que leurs niveaux, et que la géométrie du capteur a été modélisée, la réponse du capteur (le rendement de détection) est calculée pour chacune des configurations requises par le plan de « balayage ». Pour chaque rendement de détection, il faut bien intégrer la raie spectrale qui lui est associée.

Ces réponses sont ensuite analysées par un logiciel de traitement de plan d'expérience, par exemple le logiciel LUMIERE (SOFT16, LUMIERE, version 5.49). Ce logiciel fournit alors directement l'analyse de sensibilité et identifie les éléments qui influent sur la réponse du capteur à retenir. Ce logiciel permet aussi de valider le fait que tous les phénomènes influant sur la réponse du capteur sont bien identifiés et qu'aucun n'a été omis. Cette validation s'effectue par l'analyse des résidus. Une valeur élevée des résidus indique que tous les facteurs influant sur la réponse ne sont pas intégrés dans le plan d'expérience.

L'analyse qui a été effectuée sur les capteurs au germanium hyper-pur a démontré que la réponse du capteur est expliquée à 99,60% par les cinq facteurs suivants, pour un point situé à 10 cm en face du détecteur, et à 92% par ces mêmes facteurs, pour un point situé à 10 cm, à 90° par rapport à l'axe du détecteur, à savoir la longueur du cristal, le diamètre de celui-ci, et les trois « zones mortes équivalentes » respectivement situées à l'avant, à l'arrière et sur le coté.

On considère à présent la réalisation des mesures pour la détermination de la réponse spatiale du capteur.

Pour dimensionner les éléments influents, issus du plan de screening décrit dans ce qui précède, il faut réaliser des mesures de la réponse spatiale du capteur dans des positions géométriques particulières. Ces mesures doivent être réalisées avec une source de rayonnement réputée ponctuelle, c'est-à-dire une source qui est assimilable à un point géométrique pour le capteur. Cette condition doit notamment être vérifiée afin que deux mesures réalisées en deux points de l'espace différents n'interfèrent pas entre elles : on ne veut pas de recoupement géométrique des émissions de rayonnements.

Un dispositif utilisé pour remplir les conditions ci-dessus est connu par le document suivant auquel on se reportera :

**[6] ISOCS/LabSOCS, Detector characterization report, ACK#0402896, Detector S/N B05021, 3 novembre 2004.**

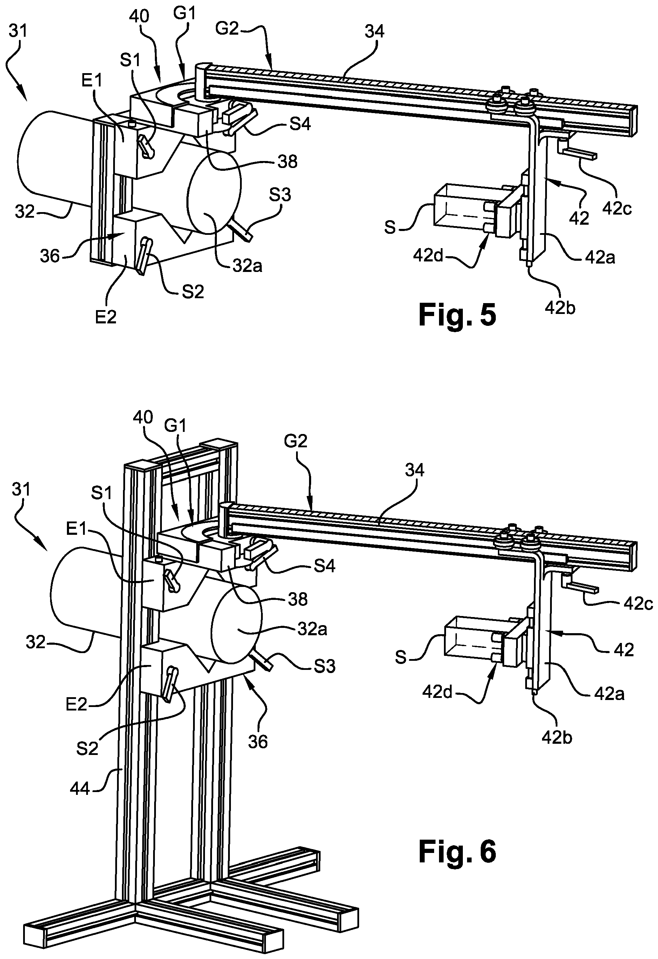

La figure 5 est une vue en perspective schématique d'un exemple du dispositif objet de l'invention, permettant l'acquisition de la réponse spatiale d'un capteur de rayonnements 31 à l'aide d'une source S desdits rayonnements. Cette source est une source étalon multifréquences (ou multiénergies). La figure 6 illustre schématiquement une variante de la figure 5, dans laquelle le dispositif de la figure 5 est complété par un dispositif de maintien au sol, réglable en hauteur.

Sur la figure 5 :

- la référence 32 désigne le capot du capteur,
- la référence 34 désigne un bras,
- la référence 36 désigne un dispositif de fixation à deux équerres, où les deux équerres ont les références El et E2,
- la référence 38 désigne une platine supérieure,
- la référence 40 désigne une tourelle,
- la référence 42 désigne un porte-source,
- la référence 42a désigne une platine de réglage,
- la référence 42b désigne un dispositif de serrage,
- la référence 42c désigne un dispositif de blocage,
- la référence 42d désigne un ensemble de quatre doigts de maintien dont seulement trois sont visibles sur la figure 5, permettant le maintien de la source S sur le porte-source 42, et
- les références S1, S2, S3 et S4 désignent des organes de serrage.

On retrouve ces références sur la figure 6 sur laquelle on voit en outre un dispositif 44 de maintien au sol, qui est réglable en hauteur et permet de maintenir le dispositif de la figure 5 sur le sol.

Dans l'exemple donné à titre purement indicatif et nullement limitatif, l'ensemble du dispositif (qui ne comprend pas le capteur muni de son capot), sans son dispositif de maintien au sol, a une masse maximale de 4 kg, pour une longueur du bras 34 égale à 50 cm (mais cette longueur pourrait être réduite, par exemple à 30 cm, si la masse maximale en question entraînait une contrainte trop forte sur le capteur). Ce dispositif de maintien est amovible. Il complète avantageusement le dispositif principal de la figure 5. En effet, il permet de réduire l'effort imposé par le couple du bras 34 lorsque le porte-source 42 est en bout de bras et que le capot 32 du capteur ne peut supporter un tel couple.

Le dispositif de la figure 5 comprend essentiellement le dispositif de fixation à deux équerres 36, la platine supérieure 38, la tourelle 40 et le porte-source 42.

Le dispositif de fixation à deux équerres 36 vient s'ajuster sur le capot 32 du capteur 31. Le maintien du dispositif d'acquisition sur le capot 32 est assuré par les quatre organes de serrage S1, S2, S3 et S4 permettant d'appuyer fermement les deux équerres E1 et E2 contre le capot 32. Le dispositif de fixation à deux équerres permet avantageusement un maintien ferme du dispositif d'acquisition sur le capot 32 du capteur 31 ainsi qu'un centrage systématique fiable du dispositif d'acquisition par rapport à la face avant du capot 32, pour n'importe quelle géométrie du capteur.

Une telle disposition permet un maintien ferme et une reproductibilité accrue des mesures par rapport au dispositif connu par le document [6].

La platine supérieure 38 supporte une languette (non représentée) et la tourelle 40. La languette, amovible ou non, fixée sur la platine 38, permet avantageusement d'ajuster l'extrémité du bras 34 avec l'extrémité de la face avant 32a du capot 32 du capteur 31. Elle assure ainsi le point de référence zéro pour les acquisitions.

La tourelle 40 reçoit l'extrémité du bras 34 permettant le maintien du porte-source 42. Cette extrémité est asservie : elle doit se trouver dans le plan défini par la face avant 32a du capot 32.

La tourelle 40 peut pivoter sur 360°. Toutefois, l'amplitude de ce mouvement sera limitée par le capteur 31. Une graduation angulaire G1 permet de relever l'angle marqué par le bras 34 par rapport au plan de la face avant du capot du capteur. En outre, une graduation G2 sur le bras 34 permet de relever la distance entre la face avant du capot du capteur et la source de rayonnements S, qui est positionnée dans le porte-source 42.

Par rapport au document [6], cela permet un multi-positionnement reproductible, avec une mesure précise d'angle et de distance. Cela permet aussi avantageusement de faire des points de vérification d'étalonnage intermédiaires, dans des positions différentes de celles qui sont utilisées pour l'étalonnage, ce que ne permet pas le dispositif connu par le document [6].

Le porte-source 42 est réglable en hauteur via la platine 42a et le dispositif de serrage 42b. Ce réglage permet d'ajuster en hauteur le centre géométrique de la source d'émission avec le centre géométrique du capot du capteur 31. La platine 42a est ajustée, à la bonne distance, le long du bras 34, par le dispositif de blocage 42c. Les quatre doigts de l'ensemble 42d sont ajustables et blocables en vue du maintien de la source de rayonnements S. L'ensemble 42d permet de recevoir plusieurs types géométriques de sources de rayonnements, du moment que les dimensions de ces sources sont compatibles avec l'espace utile entre les doigts de maintien.

L'ajustement à tout type de capot de détecteur et à différents types géométriques de sources est une caractéristique avantageuse de l'invention, que l'on ne retrouve pas dans le document [6].

Par l'intermédiaire du dispositif d'acquisition décrit ci-dessus, les mesures nécessaires pour le dimensionnement sont préférentiellement effectuées à trois angles différents (0°, 45° et 90°), pour trois distances différentes (10 cm, 20 cm et 30 cm). Et la configuration minimale requise est une mesure à 30 cm de distance, à trois angles différents (0°, 45° et 90°).

Il faut porter une attention toute particulière au nombre de raies spectrales utilisées, afin de garantir la bonne définition de la réponse du capteur. Cette réponse est exprimée sous la forme suivante :

$$rendement\ de\ détection = f\left(raie\ spectrale\right)$$

En effet, pour la détection de rayonnements gamma, si l'échantillonnage en énergie (raie spectrale) est trop espacé, surtout dans les basses énergies, alors, comme le rendement de détection évolue fortement à ces niveaux d'énergies, la définition de la réponse du capteur ne sera pas suffisante pour dimensionner correctement les éléments influents et valider ainsi la réponse fournie par la numérisation du capteur.

Il convient de noter que le dispositif d'acquisition, connu par le document [6], ne garantit pas le centrage de la source avec le centre géométrique de la face avant du capot du capteur, ni le centrage de la source avec le centre du capot. Il ne permet pas non plus d'effectuer différentes mesures cotées, à différentes distances de la face avant du capot.

On considère à présent le dimensionnement des éléments influant sur la réponse du capteur.

Ce dimensionnement est établi grâce à un plan factoriel complet. Cette catégorie de plan d'expérience est destinée à fournir l'information la plus complète possible sur des systèmes présentant un nombre restreints de facteurs qui constituent les facteurs influents. Un plan complet consiste à tester toutes les combinaisons possibles des facteurs et de leurs niveaux.

Les influences mises en avant lors du plan de screening permettent de sélectionner directement les facteurs utilisés pour le plan complet. Il faut prendre la précaution de ne conserver qu'un nombre limité de facteurs, le nombre de niveaux restant le même que dans le plan de screening, car on doit dans ce cas réaliser toutes les combinaisons possibles.

Soient $f$ le nombre de facteurs et $n$ le nombre de niveaux; le plan d'expérience est alors composé de $N = n^f$ essais.

Si le nombre de niveaux reste le même, les valeurs de chacun des niveaux peuvent toutefois être ajustées en fonction des résultats du plan de screening.

Les nouvelles valeurs des niveaux doivent permettre de dimensionner les éléments du capteur (réel) dont les facteurs sont des cotes. L'analyse des résultats quantifie, pour chaque facteur, la valeur du facteur pour le capteur (réel).

Les données d'entrée de ce plan d'expérience sont :

- la distance à laquelle la mesure a été effectuée,
- l'angle auquel la mesure a été effectuée,
- l'énergie considérée,
- le rendement de détection expérimental $\varepsilon_{exp}$, calculé comme le rapport de l'aire nette, présente dans le spectre à l'énergie considérée, au nombre de rayonnements émis par la source à l'énergie considérée, selon le certificat d'étalonnage,
- les valeurs des facteurs influents, définies par le plan d'expérience complet pour les quatre données précédentes, respectivement fixées à des valeurs particulières,
- le rendement de détection numérique $\varepsilon_{McNP}$, calculé par l'intermédiaire du code de calcul à partir de la géométrie du capteur, définie par le schéma de principe donné par le constructeur et par les valeurs des facteurs influents, définis à l'alinéa précédent.

On utilise par exemple le code de calcul MCNP. A ce sujet, on se reportera au document suivant :

**[7] Los Alamos National Laboratory, MCNPX User's manual, LANL, v.2.5, 2005**

La réponse du plan d'expérience par rapport aux données d'entrée est :

$$\hat{\varepsilon} = \frac{\varepsilon_{McNP} - \varepsilon_{exp}}{\varepsilon_{exp}}$$

Il est primordial, contrairement aux pratiques courantes, de ne pas utiliser la valeur absolue de la réponse, afin de conserver le signe de celle-ci. En effet, dans le cas contraire, on introduit un biais qui fausse le dimensionnement final des éléments.

Le plan d'expérience engendré est alors constitué des ensembles de données où, pour chaque mesure réalisée à une distance $d$ et un angle $\vartheta$, et chaque énergie d'intérêt $E_i$, $3^5 = 243$ essais (5 facteurs à 3 niveaux) sont effectués. Chacun de ces essais a pour but d'évaluer la valeur de $\varepsilon_{McNP}$ qui est associée à l'essai considéré. Un essai correspond à une configuration (dimensions des éléments) où les facteurs sont bloqués à l'un de leur niveau. Comme on dispose de 12 énergies d'intérêt dans l'exemple considéré, le nombre total de valeurs de $\hat{\varepsilon}$ utilisées, pour une position de mesure, est égal à $12 \times 243$ c'est-à-dire 2916. Comme dans l'exemple considéré il y a 9 points de mesure (autrement dit 9 couples $(d, \vartheta)$, le nombre final de valeurs de $\hat{\varepsilon}$ utilisées pour le plan complet est égal à $2916 \times 9$ c'est-à-dire 26244.

Et comme on dispose de 9 points de mesure pour 12 énergies d'intérêt, on obtient $9 \times 12$ c'est-à-dire 108 réponses.

Dans le cas considéré, le logiciel LUMIERE, dont il a été question plus haut, est limité au traitement simultané de 15 réponses. Pour pallier cette limitation, on réalise un plan d'expérience par énergie d'intérêt, d'où 12 plans d'expérience. La réponse demandée à chacun de ces plans d'expérience résulte d'un modèle de type linéaire. Elle est donnée par l'équation (1) suivante :

$$\hat{\varepsilon} = Cte + a \cdot L + b \cdot \Phi + c \cdot Zma + d \cdot Zmc + e \cdot Zmf + f \cdot L^2 + g \cdot \Phi^2 + h \cdot Zma^2 + i \cdot Zmc^2 + j \cdot Zmf^2$$

Les coefficients du modèle sont par exemple obtenus par la méthode des moindres carrés, telle qu'utilisée par le logiciel LUMIERE.

Une telle réponse ne permet aucunement de quantifier les dimensions recherchées : à partir de ces réponses, il faut procéder à la recherche du niveau optimal de chaque facteur pour une valeur de la réponse demandée. Ce niveau optimal peut être donné par exemple, par la méthode dite du « gradient réduit généralisé », telle qu'utilisée par le logiciel LUMIERE. Dans le cas présent, la condition à satisfaire, pour résoudre le système d'équations résultant de cette méthode, est que les réponses $\hat{\varepsilon}$ associées aux 12 énergies d'intérêt tendent vers 0, afin de minimiser l'erreur entre les valeurs simulées et les valeurs expérimentales.

L'utilisation que l'on fait des plans d'expérience et l'association des réponses à la méthode du gradient réduit généralisé constituent l'un des aspects originaux de l'invention pour le dimensionnement des éléments dont les dimensions géométriques ont un impact sur la réponse numérique du capteur.

Il est à noter que ce procédé présente de nombreux avantages :

1. Il évite de recourir à des relevés de cotes précis, qui sont difficiles à obtenir.

2. Il évite de recourir à une technique d'imagerie non destructive particulière. Ces deux premiers points présentent un avantage certain par rapport à l'art antérieur dans lequel le recours à l'imagerie X de haute résolution est une pratique courante pour obtenir la précision nécessaire à la définition d'un modèle numérique (toutefois avec des erreurs supérieures à celles qui résultent de la mise en oeuvre de la présente invention).

3. Si le schéma de principe ne correspond pas à la réalité, ceci est rapidement décelé car aucun modèle de comportement ne sera trouvé par le logiciel de traitement des plans d'expérience. Tout facteur affecté par cette erreur sera rapidement identifiable car la valeur attribuée à ce facteur sera le niveau maximum ou minimum du facteur considéré. Cela donnera une indication sur la cause de l'écart entre le modèle réel et le schéma de principe fourni. Les procédés de l'art antérieur ne permettent pas une telle vérification et sont susceptibles de conduire à des erreurs d'étalonnage.

4. Si l'on fait une erreur sur l'activité de la source de rayonnements, cette erreur sera décelée comme on l'explique par la suite. Les procédés de l'art antérieur ne permettent pas non plus une telle vérification, d'où d'autres erreurs d'étalonnage possibles.

5. Les capteurs fabriqués en série et de même type ne nécessiteront la réalisation du plan d'expérience complet qu'une seule fois. En effet, de tels capteurs présenteront les mêmes caractéristiques (facteurs influents et niveaux de ces facteurs). Ainsi, tout nouveau dimensionnement du même capteur ou d'un capteur semblable ne nécessitera que la réalisation des mesures de réponse spatiale et sera quantifié quasi-instantanément, en un temps égal au temps de calcul du logiciel de traitement des plans d'expérience. Actuellement, une telle procédure prend plus d'un mois. L'invention permet ainsi de passer d'un traitement au cas par cas à un traitement industriel en série.

6. Le point précédent permet la réalisation du dimensionnement par n'importe quel opérateur et non plus uniquement par un spécialiste. Il permet aussi cette réalisation autant de fois qu'on le juge nécessaire et surtout en n'importe quel lieu (notamment en laboratoire, à coté de la ligne de production des capteurs, sur le terrain, à l'extérieur). Aucun des procédés de l'art antérieur ne permet cela.

On considère à présent la validation du modèle numérique qui est dimensionné conformément au procédé selon l'invention.

La procédure décrite ci-dessus permet d'avoir une alerte automatisée sur les éventuelles erreurs qui auraient pu se produire lors de la mise en oeuvre de la présente procédure. Les sources potentielles d'erreur cosidérées ici sont l'erreur sur l'activité de la source étalon utilisée, l'erreur sur la position de la source lors des mesures et l'erreur de dimensionnement sur le schéma de principe.

Ce type d'erreur peut être détecté par trois indicateurs différents, fournis par le procédé conforme à l'invention :

1. la valeur des écart-types résiduels sur l'équation (1) associée à chaque réponse.

Une valeur élevée, supérieure à 50% par exemple, indique que la réponse n'est pas expliquée par les facteurs et que l'on ne peut donc pas expliquer la valeur du rendement de détection par les facteurs.

2. la prévision du modèle par rapport aux données expérimentales.

La cible visée est, par exemple, une prévision inférieure à 5%. On entend par là que le modèle de comportement restitue la valeur du rendement de détection avec un écart inférieur à 5% par rapport à la valeur expérimental mesurée pour le même point. Une valeur supérieure à cette cible indique que la justesse métrologique attendue n'est pas atteinte.

3. les valeurs optimisées des facteurs.

Si plusieurs de ces valeurs sont égales à la borne maximum ou à la borne minimum, cela signifie que l'on est incapable d'évaluer un modèle de comportement optimum.

Le Tableau I ci-dessous récapitule les indicateurs 1, 2 et 3 ci-dessus, permettant de trouver l'origine de l'alerte sur une erreur potentielle, commise lors du dimensionnement numérique du capteur.

Ces alertes permettent donc de s'assurer que le procédé de dimensionnement des éléments influant sur la réponse est optimal et que les valeurs optimisées, fournies par ce procédé, garantissent la quantification du rendement de détection, à un critère de convergence près (5% dans l'exemple).

Pour chaque cas, la méthodologie appliquée permet d'identifier l'erreur et sa source :

◦ impact principal sur les indicateurs 1, 2 et 3 pour une erreur de cotes sur le schéma de principe,
◦ impact principal sur les indicateurs 2 et 3 pour une erreur sur l'activité de la source,
◦ impact sur l'indicateur 1 pour une erreur de positionnement de la source.

**Tableau I : synthèse des indicateurs sur la justesse du dimensionnement numérique du capteur**

| Indicateurs | Erreur sur l'activité de la source | | | Erreur sur le positionnement de la source étalon | Cotes réelles détecteur hors des valeurs des niveaux définis d'après le schéma constructeur |
|---|---|---|---|---|---|
| Indicateurs | Erreur de 10% | Erreur de 20% | Erreur de 50% | Erreur de 50% (=7cm à 121,78keV pour un point de référence à 10cm) | erreur de 6% (4 mm) sur le diamètre donné par le schéma constructeur et de 13% (4 mm) sur la hauteur du cristal (donnée constructeur aussi) |
| 1 | Effet non significatif | Effet non significatif | Significatif: doublement de toutes les valeurs pour l'ensemble des 12 valeurs associées aux énergies | Significatif: Valeurs multipliées par un facteur de 2 à 10 pour l'ensemble des 12 modèles associés aux 12 réponses | Significatif : Valeurs multipliées par un facteur de 2 à 10 pour l'ensemble des 12 modèles associés aux 12 réponses |
| 2 | Peu significatif 2 valeurs de prévision sont au-dessus de la cible | Peu significatif 2 valeurs de prévision sont au-dessus de la cible | Significatif Toutes les valeurs de prévision sont au-dessus de la cible, d'un facteur 10 environ | Non significatif 3 valeurs de prévision sont juste au-dessus de la cible | Significatif 8 valeurs de prévision sur 12 sont au-dessus de la cible des 5% |
| 3 | Effet non significatif | Effet significatif Toutes les valeurs optimisées sont aux bornes minimales ou maximales | Effet significatif Toutes les valeurs optimisées sont aux bornes minimales ou maximales | Effet non significatif | Effet significatif 3 valeurs sur 5 sont optimisées. Les 2 valeurs non optimisées sont le diamètre du cristal et la zone morte cotée. |

Les conclusions mentionnées dans le Tableau I sont issues de l'analyse décrite ci-dessus.

On décrit ci-après le logiciel d'exploitation du procédé de dimensionnement. Ce logiciel permet d'automatiser toutes les étapes et surtout de rendre la constitution d'un modèle numérique de capteur accessible à n'importe quel opérateur et non plus seulement aux spécialistes du domaine technique considéré.

Pour cela, un tel logiciel doit :

- demander le nombre de mesures à réaliser et à quelles distances et quel angle elles sont réalisées, et demander quelles énergies d'intérêt seront utilisées,
- générer la liste des mesures à réaliser,
- récupérer, dans les spectres, les aires nettes des pics d'absorption totale pour chaque énergie d'intérêt,
- évaluer le rendement de détection expérimental pour chacune des énergies d'intérêt, à partir des données nucléaires et de l'activité de la source étalon raccordée,
- pour chaque type de capteur dont un modèle générique a été défini dans le code de calcul, pouvoir intégrer au modèle numérique prédéfini les dimensions des éléments à dimensionner, saisies par l'opérateur à partir du schéma de principe donné par le fabricant,
- générer de façon automatisée le plan d'expérience de balayage s'il s'agit de définir les éléments influant sur la réponse,
- générer les modélisations numériques correspondant aux énergies d'intérêt et aux points de mesure, et extraire les résultats du code de calcul,

- réaliser l'analyse de sensibilité permettant de déterminer les paramètres influant sur la réponse du capteur,
- une fois ces paramètres évalués, établir le plan d'expérience complet correspondant,
- générer les modélisations numériques correspondant aux énergies d'intérêt et aux points de mesure, et extraire les résultats du code de calcul,
- calculer les réponses à partir des rendements de détection expérimentaux et numérique, et optimiser les dimensions afin de fournir le modèle numérique optimal.

Les points d'arrêt concernant les erreurs éventuelles d'activité de source seront intégrés. Ils permettront ainsi d'alerter en ligne l'opérateur de la qualité de l'étalonnage réalisé.

On considère à présent la qualification du dispositif de mesure.

Le procédé, objet de l'invention, a été validé en utilisant : l'étalonnage ainsi réalisé pour quantifier l'activité d'une source étalon raccordée qui diffère, par sa nature, son activité et son positionnement, de celles qui sont utilisées pour l'étalonnage.

Il a également été validé en comparant les résultats des mesures faites sur des objets de référence, avec un étalonnage effectué à l'aide d'un procédé conforme à l'invention, et les résultats des mesures faites sur les mêmes objets, avec un étalonnage commercial. La validité de cet étalonnage commercial est garantie par le document [5] et par le document suivant :

**[8] ITECH Instruments, User's manual, Winner Track, 2009.**

Le Tableau II, ci-dessous, montre les écarts normalisés, en pourcents, entre le rendement expérimental, déterminé à partir des mesures, et le rendement de détection, fourni par des étalonnages commerciaux et par le procédé de l'invention.

Différentes géométries de capteurs, connues dans l'état de la technique, sont rappelées sur les figures 7A, 7B et 7C qui montrent respectivement, en coupe transversale, un capteur en germanium en forme de puits, de type N, un capteur en germanium en forme de puits, de type P, et un capteur en germanium de type planar. Sur ces figures, on a repéré les zones de type N+ et les zones de type P+.

**Tableau II : Tableau comparatif des écarts entre un étalonnage commercial et un étalonnage réalisé selon un procédé conforme à l'invention**

|  | Détecteur type planar1 | | Détecteur type puits | |
|---|---|---|---|---|
|  | Caractérisation Société CANBERRA | Caractérisation procédé de l'invention | Caractérisation Société ITECH | Caractérisation procédé de l'invention |
| Erreur moyenne en % (sur 30 points) | 4,08 | 3,54 | 5,9* | 3,53 |
| écart type (1σ) | 4,31 | 2,76 | 16,25* | 3,04 |
| *Ces valeurs numériques s'expliquent par un écart expérimental/modèle très élevé aux basses énergies (53 keV à 121 keV), pour des distributions angulaires comprises entre 45° et 90°. | | | | |

Tout étalonnage de capteur est primordial lorsque la quantification de la grandeur recherchée est l'objectif de la mesure effectuée. Ceci est également valable lorsque le capteur est de type spectrométrique.

Pour cette quantification, le recours à un code de calcul ou à un calcul analytique apporte une souplesse d'utilisation à ces capteurs. Cette souplesse permet la réalisation de contrôles non destructifs, notamment sur le terrain. Cette spécificité est maintenant utilisée de façon routinière et elle est indispensable à la quantification de la contamination qui est potentiellement présente sur tous les objets, tels que les déchets technologiques, qui ne peuvent, ou peuvent difficilement, être soumis à des contrôles destructifs.

Dans ce cas, l'étalonnage du capteur, c'est-à-dire la réponse de ce dernier dans l'espace, est une étape cruciale pour le couplage avec le calcul. Actuellement, la mise en oeuvre de cette étape est réservée à du personnel expert et compliquée, et il est difficile d'évaluer sa justesse métrologique. Ces difficultés font que seules quelques de sociétés sont capables de proposer de tels étalonnages, de façon plus ou moins juste.

Le dispositif et le procédé, objets de l'invention, permettent de réaliser cette étape de façon automatisée, en garantissant la robustesse métrologique de l'étalonnage ainsi réalisé. L'invention permet à toute société ou à tout opérateur de réaliser cet étalonnage, quel que soit le lieu de réalisation.

Les exemples de l'invention, donnés plus haut, concernent des capteurs de rayonnements ionisants. Mais l'invention ne se limite pas à de tels capteurs : elle s'applique à tous les capteurs de rayonnements, ionisants ou non. Et l'homme du métier peut adapter les exemples donnés plus haut à de tels capteurs.

**Revendications**

1. Procédé de quantification des dimensions intrinsèques d'un capteur de rayonnements (31), le procédé comprenant les étapes suivantes :

   - définition et réalisation d'une modélisation du capteur (31), à partir d'un schéma de principe du capteur (31),
   - identification, par un calcul numérique, des éléments influents du capteur (31), par l'intermédiaire de la théorie des plans d'expérience,
   - réalisation de mesures, pour différentes positions particulières de l'espace autour du capteur (31), au moyen d'une source étalon multifréquences (S) desdits rayonnements, et
   - dimensionnement des éléments qui influent sur la réponse du capteur (31), par l'intermédiaire de la théorie des plans d'expérience.

2. Procédé selon la revendication 1, dans lequel l'étape de détermination des éléments influents du capteur (31) est suivie d'une étape de vérification, par une méthode d'analyse des résidus, qu'aucun élément influent n'a été omis.

3. Procédé selon l'une quelconque des revendications 1 et 2, dans lequel on fait tourner la source (S) autour du capteur (31) pour réaliser les mesures sous plusieurs angles et à au moins une distance donnée du capteur (31).

4. Procédé selon l'une quelconque des revendications 1 à 3, dans lequel on recherche le niveau optimal de chaque élément influent du capteur, un niveau optimal étant un niveau pour lequel une réponse d'un plan d'expérience tend vers 0, la réponse du plan d'expérience étant égale au rapport entre, d'une part, la différence entre un rendement de détection expérimental et un rendement de détection numérique, et, d'autre part, le rendement de détection expérimental.

5. Procédé selon la revendication 4, dans lequel on recherche le niveau optimal par la méthode du gradient réduit généralisé.

6. Procédé selon l'une quelconque des revendications 1 à 5, dans lequel la source (S) est une source étalon multifréquences de rayonnements ionisants, d'activité connue, en vue de quantifier les dimensions intrinsèques d'un capteur (31) desdits rayonnements ionisants.

7. Dispositif pour la mise en oeuvre du procédé selon la revendication 1, comprenant :

   - un ordinateur configuré pour exécuter un logiciel pour la réalisation des étapes de modélisation, de détermination et de dimensionnement de la revendication 1 ;
   - un dispositif (36) de fixation du capteur (31), comprenant deux équerres (E1, E2), adapté pour maintenir fermement le capteur (31) et permettre un centrage par rapport à celui-ci,
   - un dispositif de référence, adapté pour fournir un point de référence pour les mesures,
   - un dispositif (42) de support de la source (S), et
   - un dispositif pivotant (34), solidaire du dispositif (42) de support de la source (S).

8. Dispositif selon la revendication 7, comprenant en outre un dispositif (44) amovible et réglable en hauteur, pour maintenir au sol le dispositif (36) de fixation du capteur (31).

**Patentansprüche**

1. Verfahren zum Quantifizieren der intrinsischen Abmessungen eines Strahlungssensors (31), wobei das Verfahren die folgenden Schritte umfasst:

   - Definieren und Realisieren einer Modelierung des Sensors (31) ausgehend von einem Prinzipschema des Sensors (31),
   - Identifizieren, durch eine numerische Berechnung, der beeinflussenden Elemente des Sensors (31) durch die Theorie der statistischen Versuchsplanung,

- Realisieren von Messungen für verschiedene besondere Positionen des Raums um den Sensor (31) herum mittels einer Multifrequenzeichquelle (S) der Strahlung, und

- Dimensionieren der Elemente, die die Antwort des Sensors (31) beeinflussen, durch die Theorie der statistischen Versuchsplanung.

2. Verfahren nach Anspruch 1, bei dem auf den Schritt des Bestimmens der beeinflussenden Elemente des Sensors (31) ein Schritt der Überprüfung mittels einer Methode der Residuenanalyse folgt, dass kein beeinflussendes Element ausgelassen worden ist.

3. Verfahren nach einem der Ansprüche 1 und 2, bei dem man die Quelle (S) um den Sensor (31) herum dreht, um Messungen unter mehreren Winkeln und bei wenigstens einem gegebenen Abstand von dem Sensor (31) zu realisieren.

4. Verfahren nach einem der Ansprüche 1 bis 3, bei dem man das optimale Niveau jedes beeinflussenden Elements des Sensors sucht, wobei ein optimales Niveau ein Niveau ist, für das eine Antwort eines statistischen Versuchsplans gegen 0 tendiert, wobei die Antwort des statistischen Versuchsplans gleich ist dem Verhältnis zwischen einerseits der Differenz zwischen einem experimentellen Erfassungswirkungsgrad und einem numerischen Erfassungswirkungsgrad und andererseits dem experimentellen Erfassungswirkungsgrad.

5. Verfahren nach Anspruch 4, bei dem man das optimale Niveau durch das Verfahren des generalisierten reduzierten Gradienten sucht.

6. Verfahren nach einem der Ansprüche 1 bis 5, bei dem die Quelle (S) eine Multifrequenz-Eichquelle von ionisierenden Strahlen mit bekannter Aktivität im Hinblick auf eine Quantifizierung der intrinsischen Abmessungen eines Sensors (31) für die ionisierenden Strahlen ist.

7. Vorrichtung zur Durchführung des Verfahrens nach Anspruch 1, umfassend:

   - einen Computer, der dazu ausgelegt ist, eine Software für die Durchführung der Schritte zur Modellierung, zur Bestimmung und zur Dimensionierung des Anspruchs 1 auszuführen;
   - eine Vorrichtung (36) zur Befestigung des Sensors (31), umfassend zwei Winkelstücke (E1, E2), die dazu ausgelegt sind, den Sensor (31) fest zu halten und eine Zentrierung bezüglich desselben zu ermöglichen,
   - eine Referenzvorrichtung, die dazu ausgelegt ist, einen Referenzpunkt für die Messungen zu liefern,
   - eine Vorrichtung (42) zum Tragen der Quelle (S), und
   - eine Schwenkvorrichtung (34), die mit der Vorrichtung (42) zum Tragen der Quelle (S) verbunden ist.

8. Vorrichtung nach Anspruch 7, ferner umfassend eine abnehmbare und höheneinstellbare Vorrichtung (44) zum Halten der Vorrichtung (36) zur Befestigung des Sensors (31) am Boden.

**Claims**

1. Method of quantifying the intrinsic dimensions of a radiation sensor (31), the method comprising the following steps:

   - defining and producing of a model of the sensor (31), starting from a block diagram of the sensor (31),
   - using a digital calculation, identifying the influential elements of the sensor (31), through the use of the experience plans theory,
   - making measurements, for each particular position in the space around the sensor (31), using a standard multifrequency source (S) of said radiation, and
   - determining the sizes of the elements that influence the response of the sensor (31), through the use of the experience plans theory.

2. Method according to claim 1, wherein the step of identifying the influential elements of the sensor (31) is followed by a step of verifying, using a residue analysis method, that no influential element has been omitted.

3. Method according to any one of claims 1 or 2, in which the source (S) is rotated around the sensor (31) to make measurements at several angles and at at least one given distance from the sensor (31).

4. Method according to any one of claims 1 to 3, wherein the optimum level of each influential element of the sensor is looked for, an optimum level being a level for which a response of an experience plan tend towards 0, the response of the experience plan being equal to the ratio of, on one hand, the difference between a digital detection efficiency and an experimental detection efficiency, to, on the other hand, the experimental detection efficiency.

5. Method according to claim 4, in which the generalised reduced gradient method is used to find the optimum level.

6. Method according to any one of claims 1 to 5, in which the source (S) is a standard multifrequency source of ionising radiation with a known activity in order to quantify the intrinsic dimensions of a sensor (31) of said ionising radiation.

7. Device for implementation of the method according to claim 1, comprising:

   - a computer configured to run software for performing the steps of definition of a model, of identification and of determination of claim 1,
   - an attachment device (36) for attaching the sensor (31), comprising two brackets (E1, E2), adapted for holding the sensor (31) firmly and allowing centring relative to the sensor,
   - a reference device adapted to provide a reference point for the measurements,
   - a support device (42) for supporting the source (S), and
   - a pivoting device (34) fixed to the support device (42) for supporting the source (S).

8. Device according to claim 7, further comprising a removable device (44) with adjustable height to hold on the floor the attachment device (31) for attaching the sensor (36).

Fig. 1

Fig. 2

Fig. 3A

Fig. 3B

**Fig. 4**

**Fig. 7A**

**Fig. 7B**

**Fig. 7C**

**Fig. 5**

**Fig. 6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9839628 A, F. Bronson

- WO 2014085081 A1

**Littérature non-brevet citée dans la description**

- **F. BRONSON et al.** Validation of the MCNP Monte Carlo Code for germanium detector gamma efficiency calibrations. *Canberra Industries, U.S.A.,* 1996
- **R. VENKATARAMAN et al.** Improved detector response characterization method in ISOCS and LabSOCS. *Journal of Rad. Nucl. Chem.,* 2005, vol. 264, 213-219

- Validation of in situ object counting system (ISOCS) mathematical efficiency calibration software. **VENKATARAMAN R et al.** NUCLEAR INSTRUMENTS & METHODS IN PHYSICS RESEARCH. SECTION A: ACCELERATORS, SPECTROMETERS, DETECTORS, AND ASSOCIATED EQUIPMENT. ELSEVIER BV, 11 Février 1999, vol. 422, 450-454